(19) Europäisches Patentamt / European Patent Office / Office européen des brevets

(11) **EP 1 796 140 A1**

(12) **EUROPEAN PATENT APPLICATION**
published in accordance with Art. 158(3) EPC

(43) Date of publication:
**13.06.2007 Bulletin 2007/24**

(51) Int Cl.:
*H01L 21/027* (2006.01)  *B29C 59/02* (2006.01)
*B30B 15/06* (2006.01)  *B81C 5/00* (2006.01)
*B82B 3/00* (2006.01)

(21) Application number: **05767138.0**

(22) Date of filing: **28.07.2005**

(86) International application number:
**PCT/JP2005/013880**

(87) International publication number:
**WO 2006/011576 (02.02.2006 Gazette 2006/05)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **29.07.2004 JP 2004222162**

(71) Applicants:
• **Scivax Corporation**
**Tokyo 103-0004 (JP)**
• **Hakuto Co., Ltd**
**Shinjuku-ku,**
**Tokyo 160-8910 (JP)**
• **Engineering System Co., Ltd**
**Matsumoto-City**
**Nagano 3990033 (JP)**

(72) Inventors:
• **KUSUURA, Takahisa**
**Chuo-Ku, Tokyo 1030004 (JP)**
• **GOTO, Hiroshi**
**Ushiku-shi, Ibaraki 3001216 (JP)**
• **KOBAYASHI, Naoki**
**Nagano 3990033 (JP)**

(74) Representative: **Howe, Steven**
**Lloyd Wise**
**Commonwealth House,**
**1-19 New Oxford Street**
**London WC1A 1LW (GB)**

(54) **INCLINATION ADJUSTING DEVICE AND PATTERN FORMING DEVICE WITH INCLINATION ADJUSTING FUNCTION**

(57) An inclination adjusting device included in a pattern formation device that presses a mold, which has a predetermined pattern, and a processing object to transfer the pattern of the mold on the processing object, adjusting an inclination of the mold with the processing object, and comprising

a projected spherical surface seat having a projected spherical surface whose inclination is fixed with respect to the mold,

a recessed spherical surface seat having a recessed spherical surface which has the same diameter as that of the projected spherical surface and an inclination fixed with respect to the processing object, and abuts with the projected spherical surface, and

displacement means for causing the projected spherical surface and the recessed spherical surface to be relatively displaced.

FIG.4

**EP 1 796 140 A1**

## Description

Technical Field

The present invention relates to a device for adjusting an inclination of, for example, a processing object with a mold, and a pattern formation device using the same.

Background Art

Recently, a technique so called a photolithography has been generally used for forming a fine circuit pattern represented by an LSI (Large Scale Integrated circuit) on a semiconductor substrate (hereinafter referred to simply as substrate). In the method, using an exposure device called a stepper, a circuit pattern rendered on a reticle (mask) is projection-exposed on a resist surface on a substrate through a reduced optical system, and the exposure is repeated over the entire region of the substrate, thereby forming a predetermined fine circuit pattern on the substrate.

To increase the integration degree of the substrate formed by the foregoing method, it is necessary to reduce the line width of the circuit pattern, and it is expected that the line width will shift from a currently mainstream line width of 130 nm to a line width of 100 nm or less in the future.

For keeping up with this trend, it is necessary to reduce a wavelength of a light source used for projection exposure, and in the present circumstances, individual manufactures of exposure devices are developing exposure devices using light of short wavelengths, such as ultraviolet (UV) light, deep ultraviolet (DUV) light and extreme ultraviolet (EUV) light as light sources.

If light with a short wavelength like an ultraviolet laser light source is used as a light source, however, distortions and light source noises occur in a lens, a mirror and a light source and the like constituting a projection optical system of exposure devices, due to a small change in temperature and external vibrations. Thus, precise temperature control and a vibration isolating structure are required for the exposure device, and resultantly the price of the reduced projection type exposure device constituted by a series of such devices tends to be extremely high (e.g. several billions yens). In addition, the exposure device itself has a large size, and therefore an installation space and electric power consumption tend to increase.

In view of rising in the scale of such devices and process costs, a nanoimprinting process technique has been developed as an another method for forming a very fine pattern on a substrate (see, for example, G.M. Whitesides, J. C. Love, "New Technique for Fabricating Nano Structures", "Nikkei Science", Nihon Keizai Shinbun, Inc. December 1, H13 (2001), vol. 31, No. 12, pages 30 to 41).

The process is a method of using a mold having a pattern subject to formation on the surface thereof, heating a processing object like a substrate to a temperature over the glass transition point of a resist material provided on the processing target, pressing a mold in this state against the surface of the processing object, thereby transferring the pattern on the mold. The method does not require expensive laser light sources and optical systems, can transfer the pattern formed on the mold directly and precisely even through it employs a simple structure basically comprised of a heater for heating and a press device, and there is already a report to the effect that a thin line having a line width of approximately 20 nm has been formed by the foregoing method (see, for example, C. M. Sotomayor, et. al., "Nanoimprint lithography: an alternative nanofabrication approach", "Materials Science & Engineering C", Elsevier Science, H14 (2002), vol. 989, pages 1 to 9).

A circumstance where fabrication of various microchips and micro devices, such as optical devices like diffraction gratings, photonic crystals, and waveguides, and fluidic devices like micro channels, and reactors are possible is about to be realized by using such a nanoimprinting process technique.

Adjusting an inclination of a mold with a processing object is very important in a fine processing less than or equal to 100 $\mu$m by such a nanoimprinting process technique. This is because that if the mold inclines with respect to the processing object, the mold is subjected to unparallel contact due to inclination even if the mold is pressed against the processing object by uniform force, so that the contour of the mold cannot be transferred precisely on the surface of the processing object. In cases of optical devices and fluidic devices where the processing precision in the depth direction of the devices affects the performances of the devices, the deterioration in the molding precision originating from the inclination is fatal.

Conventionally, there is a method of manually setting the mold parallel to the processing object using shims to correct the inclination. There is also a method of setting the mold parallel to the processing object using a piezo device. Further, there is a method of automatically setting the mold parallel to the processing object in pressing by mold holding means provided with a multi-degree-of-freedom link mechanism. Still further, there is a method of pressing the mold which is constituted by a freely-deformable thin plate by hydrostatic fluid pressure, thereby generating uniform pressing force.

Disclosure of the Invention

Problem to be solved by the Invention

The method of using shims has, however, problems such that it is necessary to prepare shims having various thicknesses and it is impossible to figure out a current adjustment state at a glance.

The method of using a piezo device has a problem such that as force is directly applied to the device, the device is likely to break up, so that the durability is low.

The method of mold holding means provided with a multi-degree-of-freedom link mechanism has a problem such that because the mold is held in parallel by force applied from the substrate, the force applied from the substrate becomes ununiform when a pattern is ununiform, and the mold and the substrate becomes unparallel to each other, resulting in occurrence of reduction of the molding precision.

According to the method of pressing the mold which is constituted by the freely-deformable thin plate by hydrostatic fluid pressure, there is a problem such that because inclination adjustment is performed in mold processing with the mold pressed against the molding substrate, certain pressing force which can correct an inclination becomes necessary, and the method cannot be applied to a processing object which is formed by force less than or equal to the pressing force.

Further, according to the conventional method, because an adjustment mechanism is present at a position where force is applied from press means, the adjustment mechanism is deformed or broken when large force is applied, so that there are problems in precision and strength.

Therefore, it is an object of the present invention to provide an inclination adjusting device having higher precision and strength than conventional devices, and a pattern formation device using the same.

Means for Solving the Problem

To achieve the object, a first inclination adjusting device of he invention is included in a pattern formation device that presses a mold, which has a predetermined pattern, and a processing object to transfer the pattern of the mold on the processing object, adjusts an inclination of the mold with the processing object, and comprises: a projected spherical surface seat having a projected spherical surface whose inclination is fixed with respect to the mold; and a recessed spherical surface seat having a recessed spherical surface which has a same diameter as a diameter of the projected spherical surface and an inclination fixed with respect to the processing object, and abuts with the projected spherical surface. The first inclination adjusting device of the invention may be included in a pattern formation device that presses a mold, which has a predetermined pattern, and a processing object to transfer the pattern of the mold on the processing object, adjust an inclination of the mold with the processing object, and comprise: a recessed spherical surface seat having a recessed spherical surface whose inclination is fixed with respect to the mold; and a projected spherical surface seat having a projected spherical surface which has a same diameter as a diameter of the recessed spherical surface and an inclination fixed with respect to the processing object, and abuts with the recessed spherical surface.

In this case, it is preferable that the inclination adjusting device should comprise displacement means for causing the projected spherical surface and the recessed spherical surface to be relatively displaced. It is preferable that the displacement means should comprise a first adjusting instrument and a second adjusting instrument which press the projected spherical surface seat or the recessed spherical surface seat in directions opposite to each other to cause the projected spherical surface and the recessed spherical surface to be relatively displaced, and a third adjusting instrument and a fourth adjusting instrument which presses the projected spherical surface seat or the recessed spherical surface seat in directions orthogonal to press directions of the first adjusting instrument and the second adjusting instrument and opposite to each other to cause the projected spherical surface and the recessed spherical surface to be relatively displaced. It is preferable that the projected spherical surface and the recessed spherical surface should be formed in such a way that centers of spheres thereof match with a center of the pattern face. It is preferable that a topcoat layer having a higher hardness than those of the projected spherical surface and the recessed spherical surface or a topcoat layer having a smaller coefficient of friction than those of the projected spherical surface and the recessed spherical surface should be formed on at least one of the projected spherical surface and the recessed spherical surface. It is preferable that the inclination adjusting device should comprise: inclination detection means for detecting a relative inclination between the mold and the processing object; and control means for controlling the displacement means based on an inclination detected by the inclination detection means, and adjusting an displacement of causing the projected spherical surface and the recessed spherical surface to be relatively displaced. It is preferable that the inclination adjusting device should comprise fixing means for fixing the projected spherical surface seat and the recessed spherical surface seat in a normal line direction of the projected spherical surface.

A first pattern formation device of the invention presses a mold, which has a predetermined pattern, and a processing object to transfer the pattern of the mold on the processing object, and comprises: a projected spherical surface seat having a projected spherical surface whose inclination is fixed with respect to the mold; a recessed spherical surface seat having a recessed spherical surface which has a same diameter as a diameter of the projected spherical surface and an inclination fixed with respect to the processing object, and abuts with the projected spherical surface; and press means for pressing the mold and the processing object. The first pattern formation device of the invention may press a mold, which has a predetermined pattern, and a processing object to transfer the pattern of the mold on the processing object, and comprise: a recessed spherical surface seat having a recessed spherical surface whose inclination is fixed with respect to the mold; a projected spherical surface seat having a projected spherical surface which has a same diameter as a diameter of the recessed spherical surface and an inclination fixed with respect to the processing object, and abuts with the recessed spherical surface; and press means for pressing the mold and the processing object.

In this case, it is preferable that the pattern formation device should comprise displacement means for causing the projected spherical surface and the recessed spherical surface to be relatively displaced. It is preferable that the displacement means should comprise a first adjusting instrument and a second adjusting instrument which press the projected spherical surface seat or the recessed spherical surface seat in directions opposite to each other to cause the projected spherical surface and the recessed spherical surface to be relatively displaced, and a third adjusting instrument and a fourth adjusting instrument which press the projected spherical surface seat or the recessed spherical surface seat in directions orthogonal to press directions of the first adjusting instrument and the second adjusting instrument and opposite to each other to cause the projected spherical surface and the recessed spherical surface to be relatively displaced. It is preferable that the projected spherical surface and the recessed spherical surface should be formed in such a way that centers of spheres thereof match with a center of the pattern face. It is preferable that a topcoat layer having a higher hardness than those of the projected spherical surface and the recessed spherical surface or a topcoat layer having a smaller coefficient of friction than those of the projected spherical surface and the recessed spherical surface should be formed on at least one of the projected spherical surface and the recessed spherical surface. It is preferable that the pattern formation device should comprise: inclination detection means for detecting a relative inclination between the mold and the processing object; and control means for controlling the displacement means based on an inclination detected by the inclination detection means, and adjusting an displacement of causing the projected spherical surface and the recessed spherical surface to be relatively displaced. It is preferable that the pattern formation device should comprise fixing means for fixing the projected spherical surface seat and the recessed spherical surface seat in a normal line direction of the projected spherical surface.

A second inclination adjusting device of the invention is included in a pattern formation device that presses a mold, which has a predetermined pattern, and a processing object to transfer the pattern of the mold on the processing object, and comprises: a first projected circular-arcuate surface seat having a first projected circular-arcuate surface whose inclination is fixed with respect to the mold, and whose cut plane is formed in a projected circular-arcuate shape; a first recessed circular-arcuate surface seat having a first recessed circular-arcuate surface whose cut plane is formed in a recessed circular-arcuate shape, and which has a same diameter as a diameter of the first projected circular-arcuate surface, and abuts with the first projected circular-arcuate surface; a second projected circular-arcuate surface seat having a second projected circular-arcuate surface whose inclination is fixed with respect to the first recessed circular-arcuate surface, and whose cut plane is formed in a projected circular-arcuate shape, and which is formed in a predetermined direction not parallel to an axial direction of the first recessed circular-arcuate surface; and a second recessed circular-arcuate surface seat having a second recessed circular-arcuate surface whose inclination is fixed with respect to the processing object, and whose cut plane is formed in a recessed circular-arcuate shape, and which has a same diameter as a diameter of the second projected circular arcuate surface, and abuts with the second projected circular-arcuate surface. The second inclination adjusting device of the invention may be included in a pattern formation device that presses a mold, which has a predetermined pattern, and a processing object to transfer the pattern of the mold on the processing object, and comprise: a first recessed circular-arcuate surface seat having a first recessed circular-arcuate surface whose inclination is fixed with respect to the mold, and whose cut plane is formed in a recessed circular-arcuate shape; a first projected circular-arcuate surface seat having a first projected circular-arcuate surface whose cut plane is formed in a projected circular-arcuate shape, and which has a same diameter as a diameter of the first recessed circular-arcuate surface, and abuts with the first recessed circular-arcuate surface; a second recessed circular-arcuate surface seat having a second recessed circular-arcuate surface whose inclination is fixed with respect to the first projected circular-arcuate surface, and whose cut plane is formed in a projected circular-arcuate shape, and which is formed in a predetermined direction not parallel to an axial direction of the first projected circular-arcuate surface; and a second projected circular-arcuate surface seat having a second projected circular-arcuate surface whose inclination is fixed with respect to the processing object, and whose cut plane is formed in a projected circular-arcuate shape, and which has a same diameter as a diameter of the second recessed circular arcuate surface, and abuts with the second recessed circular-arcuate surface.

In this case, it is preferable that the inclination adjusting device should comprise: first displacement means for causing the first projected circular-arcuate surface and the first recessed circular-arcuate surface to be relatively displaced; and second displacement means for casing the second projected circular-arcuate surface and the second recessed circular-arcuate surface to be relatively displaced. It is preferable that the first displacement means should comprise a first adjusting instrument and a second adjusting instrument which press the first projected circular-arcuate surface seat or the first recessed circular-arcuate surface seat in directions opposite to each other to cause the first projected circular-arcuate surface and the first recessed circular-arcuate surface to be relatively displaced, and the second displacement means should comprise a third adjusting instrument and a fourth adjusting instrument which press the second projected circular-arcuate surface seat or the second recessed circular-arcuate surface seat in directions orthogonal to press directions of the first adjusting instrument and the second adjusting instrument and opposite to each other to cause the second projected circular-arcuate surface and the second recessed circular-arcuate surface to be relatively displaced. It is preferable that a topcoat layer having a higher hardness than those of the first projected circular-arcuate surface, the first recessed circular-arcuate surface, the second projected circular-arcuate surface, and the second recessed circular-arcuate surface, or a topcoat layer having a smaller coefficient of friction than those of the first projected circular-arcuate surface, the first recessed circular-arcuate surface, the second projected circular-arcuate surface, and the second recessed circular-arcuate surface should be formed on at least one or more of the first projected circular-arcuate surface, the first recessed circular-arcuate surface, the second projected circular-arcuate surface, and the second recessed circular-arcuate surface. It is preferable that the inclination adjusting device should comprise: inclination detection means for detecting a relative inclination between the mold and the processing object; and control means for controlling the first displacement means and the second displacement means based on an inclination detected by the inclination detection means, and adjusting an displacement of causing the first projected circular-arcuate surface and the first recessed circular-arcuate surface to be relatively displaced and an displacement of causing the second projected circular-arcuate surface and the second recessed circular-arcuate surface to be relatively displaced. It is preferable that the inclination adjusting device should comprise: first fixing means for fixing the first projected circular-arcuate surface seat and the first recessed circular-arcuate surface seat in a normal line direction of the first projected circular-arcuate surface; and second fixing means for fixing the second projected circular-arcuate surface seat and the second recessed circular-arcuate surface seat in a normal line direction of the second projected circular-arcuate surface.

A second pattern formation device of the invention is a pattern formation device that presses a mold, which has a predetermined pattern, and a processing object to transfer the pattern of the mold on the processing object, comprising: a first projected circular-arcuate surface seat having a first projected circular-arcuate surface whose inclination is fixed with respect to the mold, and whose cut plane is formed in a projected circular-arcuate shape; a first recessed circular-arcuate surface seat having a first recessed circular-arcuate surface whose cut plane is formed in a recessed circular-arcuate shape, and which has a same diameter as a diameter of the first projected circular-arcuate surface, and abuts with the first projected circular-arcuate surface; a second projected circular-arcuate surface seat having a second projected circular-arcuate surface whose inclination is fixed with respect to the first recessed circular-arcuate surface, and whose cut plane is formed in a projected circular-arcuate shape, and which is formed in a predetermined direction not parallel to an axial direction of the first recessed circular-arcuate surface; a second recessed circular-arcuate surface seat having a second recessed circular-arcuate surface whose inclination is fixed with respect to the processing object, and whose cut plane is formed in a recessed circular-arcuate shape, and which has a same diameter as a diameter of the second projected circular arcuate surface, and abuts with the second projected circular-arcuate surface; and press means for pressing the mold and the processing object. The second pattern formation device of the invention may be a pattern formation device that presses a mold, which has a predetermined pattern, and a processing object to transfer the pattern of the mold on the processing object, and comprise: a first recessed circular-arcuate surface seat having a first recessed circular-arcuate surface whose inclination is fixed with respect to the mold, and whose cut plane is formed in a recessed circular-arcuate shape; a first projected circular-arcuate surface seat having a first projected circular-arcuate surface whose cut plane is formed in a projected circular-arcuate shape, and which has a same diameter as a diameter of the first recessed circular-arcuate surface, and abuts with the first recessed circular-arcuate surface; a second recessed circular-arcuate surface seat having a second recessed circular-arcuate surface whose inclination is fixed with respect to the first projected circular-arcuate surface, and whose cut plane is formed in a recessed circular-arcuate shape, and which is formed in a predetermined direction not parallel to an axial direction of the first projected circular-arcuate surface; a second projected circular-arcuate surface seat having a second projected circular-arcuate surface whose inclination is fixed with respect to the processing object, and whose cut plane is formed in a projected circular-arcuate shape, and which has a same diameter as a diameter of the second recessed circular arcuate surface, and abuts with the second recessed circular-arcuate surface; and press means for pressing the mold and the processing object.

In this case, it is preferable that the second pattern formation device should comprise: first displacement means for causing the first projected circular-arcuate surface and the first recessed circular-arcuate surface to be relatively displaced; and second displacement means for casing the second projected circular-arcuate surface and the second recessed circular-arcuate surface to be relatively displaced. It is preferable that the first displacement means should comprise a first adjusting instrument and a second adjusting instrument which press the first projected circular-arcuate surface seat or the first recessed circular-arcuate surface seat in directions opposite to each other to cause the first projected circular-arcuate surface and the first recessed circular-arcuate surface to be relatively displaced, and the second displacement means should comprise a third adjusting instrument and a fourth adjusting instrument which press the second projected circular-arcuate surface seat or the second recessed circular-arcuate surface seat in directions orthogonal to press directions of the first adjusting instrument and the second adjusting instrument and opposite to each other to cause the second projected circular-arcuate surface and the second recessed circular-arcuate surface to be relatively displaced. It is preferable that a topcoat layer having a higher hardness than those of the first projected circular-arcuate surface, the first recessed circular-arcuate surface, the second projected circular-arcuate surface, and the second recessed circular-arcuate surface, or a topcoat layer having a smaller coefficient of friction than those of the first projected circular-arcuate surface, the first recessed circular-arcuate surface, the second projected circular-arcuate surface, and the second recessed circular-arcuate surface should be formed on at least one or more of the first projected circular-arcuate surface, the first recessed circular-arcuate surface, the second projected circular-arcuate surface, and the second recessed circular-arcuate surface. It is preferable that the second pattern formation device should comprise: inclination detection means for detecting a relative inclination between the mold and the processing object; and control means for controlling the first displacement means and the second displacement means based on an inclination detected by the inclination detection means, and adjusting an displacement of causing the first projected circular-arcuate surface and the first recessed circular-arcuate surface to be relatively displaced and an displacement of causing the second projected circular-arcuate surface and the second recessed circular-arcuate surface to be relatively displaced. It is preferable that the second pattern formation device should comprise: first fixing means for fixing the first projected circular-arcuate surface seat and the first recessed circular-arcuate surface seat in a normal line direction of the first projected circular-arcuate surface; and second fixing means for fixing the second projected circular-arcuate surface seat and the second recessed circular-arcuate surface seat in a normal line direction of the second projected circular-arcuate surface.

Brief Description of Drawings

[FIG. 1] A schematic front view illustrating a pattern formation device of the invention.
[FIG. 2] A cross-sectional side view as viewed along a line I-I in FIG. 1.
[FIG. 3] A schematic front view illustrating the major parts of the pattern formation device of the invention.
[FIG. 4] A schematic cross-sectional view illustrating the major parts of mold holding means.

[FIG. 5] A partial cross-sectional view illustrating the major parts of the pattern formation device of the invention.
[FIG. 6] A cross-sectional view as viewed along a line II-II in FIG. 3.
[FIG. 7] A front view illustrating the major parts of a pattern formation device according to a second embodiment of the invention.
[FIG. 8] A side view illustrating the major parts of the pattern formation device according to the second embodiment of the invention.

Best Mode for Carrying Out the Invention

Embodiments of the invention will be explained in detail with reference to the accompanying drawings.

First Embodiment

A pattern formation device 10 of the invention generally comprises a device main body 15, a mold 100 on which a predetermined pattern to be transferred on a processing object 200 is formed, object holding means 20 for holding the processing object 200, mold holding means 40 for holding the mold 100, press means 50 for pressing the mold 100 against the processing object 200, a projected spherical surface seat 47 having a projected spherical surface 46 whose inclination is fixed with respect to the mold 100, a recessed spherical surface seat 57 having a recessed spherical surface 55 which has the same diameter as that of the projected spherical surface 46 and whose inclination is fixed with respected to the processing object 200, and which abuts with the projected spherical surface 46, and displacement means 60 for causing the projected spherical surface 46 and the recessed spherical surface 55 to be relatively displaced. The pattern formation device may further has inclination detection means for detecting a relative inclination of the mold 100 with the processing object 200, and control means for controlling displacement of the displacement means 60 based on the inclination detected by the inclination detection means, thereby automatically adjusting the inclination. Note that the projected spherical surface seat 47, the recessed spherical surface seat 57, and the displacement means 60 constitute an inclination adjusting device.

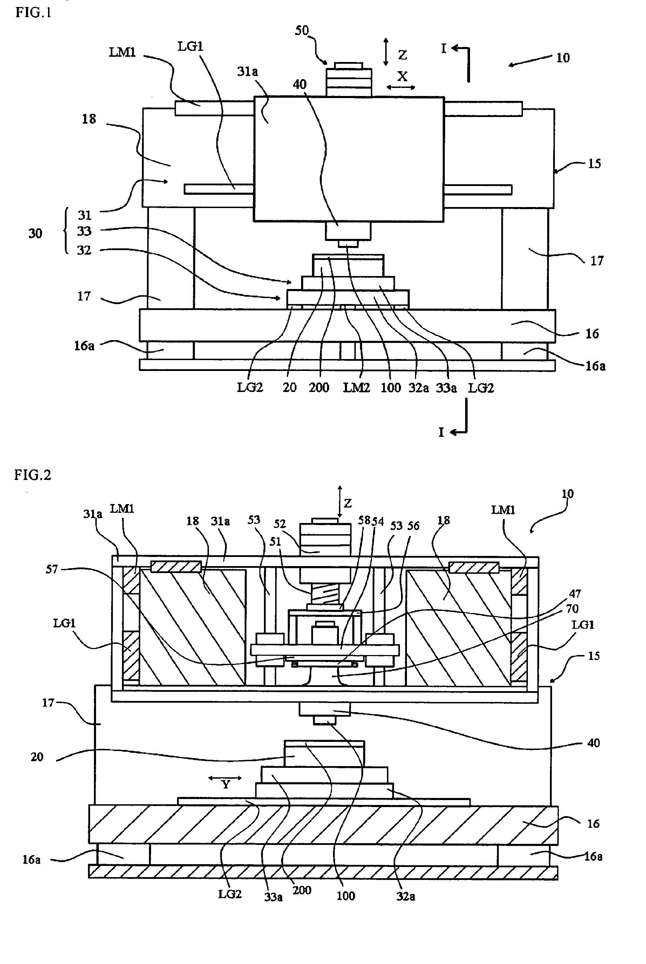

As illustrated in FIG. 1 and FIG. 2, the device main body 15 comprises a tabular base mount 16 which supports the object holding means 20 on the top face thereof, side walls 17 so fixed to both end portions of the top face of the base mount 16 as to be in parallel with each other, and an upper base 18 disposed in a direction orthogonal to the side walls 17, fixed to the end portions of the top faces of the side walls 17 in a parallelized manner, and which supports the mold holding means 40. The device main body 15 is formed of a material, e.g., a stone like granite which has a low thermal conductivity, and is rigid so as not to be easily deformed by external force, surrounding temperature, and the like. This quickly prohibits occurrence of an error in a positional relationship between the object holding means 20 and the mold holding means 40 originating from change in a surrounding environment.

The device main body 15 is disposed on the ground or the like through base isolation mechanisms 16a formed below the base mount 16. Accordingly, it is possible to prohibit transferring of vibrations generated when a person walks, vibrations generated by other devices, and minute vibrations generated due to a surrounding environment to the device main body 15.

The processing object 200 varies, and is, for example, a raw material subject to molding which is formed in a substrate-like shape as it is, such as a resin of polycarbonate, polyimide, or the like, a metal of aluminum, and a material of glass, silica glass, silicon, gallium arsenide, sapphire, magnesium oxide, and the like. One having a covering layer or the like, such as a resin, a photoresist, and a metallic thin film of aluminum, gold, silver, or the like for forming a wiring pattern, formed on the surface of a substrate main body made of silicon, glass, or the like may be used. Further, the processing object 200 may be formed in, for example, a film-like shape other than the substrate-like shape.

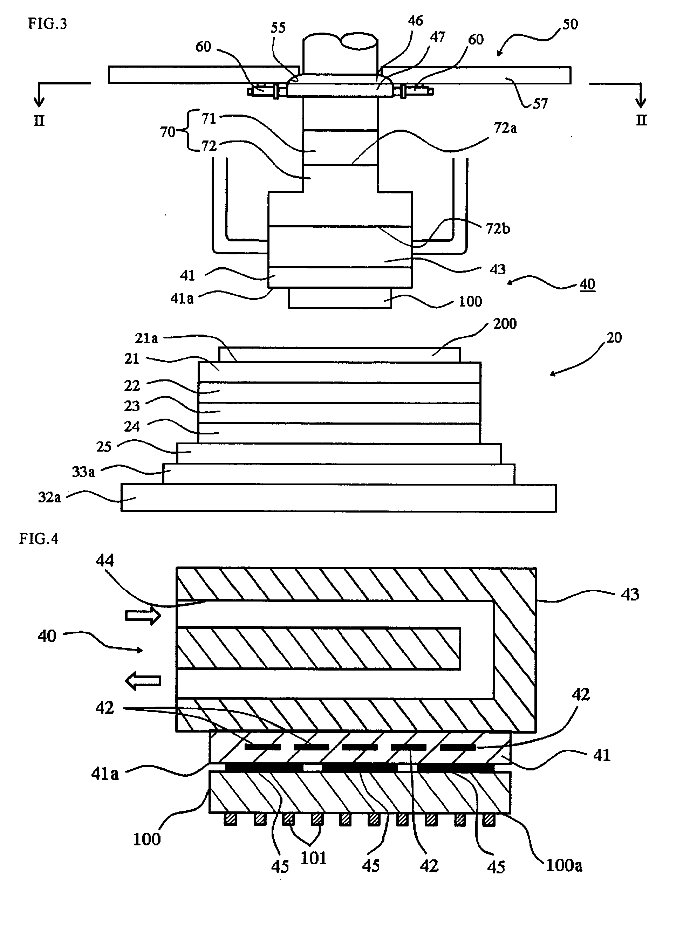

As illustrated in FIG. 4, the mold 100 has a pattern face 100a, which is formed on the bottom face thereof, and is provided with projections and depressions 101 for forming a predetermined pattern. The projections and depressions 101 can be formed by performing precise machining on the pattern face 100a of the mold 100 which is formed of a metal like nickel, a ceramic, a carbon material, or the like. A predetermined pattern is formed on a silicon substrate or the like which becomes the master of the mold 100 by a semiconductor fine processing technique like etching, a metal plating is formed on the surface of the silicon substrate or the like by a nickel plating method (electroforming method) or the like, and the metal plating layer is peeled, thereby forming the mold 100 having the projections and depressions 101. The material and the manufacturing method of the mold 100 are not limited to specific ones as long as a fine pattern can be formed. The width of the projections and depressions 101 varies depending on the kind of the processing object 200 to be used, and is formed to, less than equal to 100 $\mu$m, preferably, less than or equal to 10 $\mu$m, further preferably, less than or equal to 100 nm, and still further preferably, less than or equal to 10 nm. Because the mold 100 is heated and cooled by a heater 42 and a cooling block 43 of the mold holding means 40 to be discussed later, it is preferable that the mold should be made thin as much as possible to reduce the heat capacity thereof as much as possible.

As illustrated in FIG. 3, the object holding means 20 holds the processing object 200 in a substantially parallel state, and has a holding stage 21 having a holding surface 21a formed on the top face thereof.

The holding stage 21 has multiple vacuum holes (not illustrated) formed in the holding surface 21a, and as negative pressure is applied through the vacuum holes from a non-illustrated negative pressure source, the processing object 200 is adsorbed and held on the holding surface 21a.

As illustrated in FIG. 3, object heating means, e.g., a heater 22 for heating the held processing object 200 is provided below the holding stage 21. Operation of the heater 22 is so controlled by a non-illustrated controller in such a manner as to maintain the temperature of the processing object 200 on the holding stage 21 at a certain temperature. A possible heater 22 is a heat exchange heater, or preferably, a ceramic heater to be discussed later in detail.

The object holding means 20 also has a cooling means 24 below the heater 22 via a heat insulating material (heat insulating means) 23, and can suppress heat generated by the heater 22 from being transferred to a θ stage 25 side to be discussed later. Therefore, it is possible to prevent a movement mechanism 30 and the device main body 15 from being deformed by heat to thereby prohibit occurrence of an error between the pattern on the mold 100 and a substrate. The heat insulating material 23 may be of any materials which can suppress thermal conduction, and a metal, a ceramic, or the like can be used, but a material having a preferable thermal conductivity less than or equal to 0.3 W/m·k, and further preferably, less than or equal to 0.25 W/m·k is preferably used. A possible cooling means 24 is, for example, a metal having a large thermal conductivity like aluminum or copper structured in such a manner as to have a channel formed thereinside through which a coolant like a cooling water flows. The cooling means 24 may be connected to, for example, a non-illustrated controller, and controlled in such a manner as to suppress the temperature of the θ stage 25 from rapidly rising based on a detection signal from temperature detection means for detecting the temperature of the θ stage 25. Needless to say, another means like a Peltier device can be used as long as thermal conduction to the θ stage 25 is prevented.

The object holding means 20 is formed in such a manner as to be displaced in two directions by Y-direction movement means 32 which can linearly move the object holding means 20 in a predetermined direction (hereinafter called Y direction) within a plane parallel to the top face of the processing object 200, and a rotation means 33 which can rotate the object holding means within a plane parallel to the top face of the processing object 200.

The Y-direction movement means 32 comprises, a Y stage 32a which holds, for example, the object holding means 20 and a θ stage 33 to be discussed later, a linear motor LM2 which is fixed to the base mount 16 and applies Y-directional driving force to the Y stage 32a, and a linear guide LG2 which is fixed to the base mount 16 and supports the Y stage 32a movable in the Y direction. Materials having a high rigidity are used for the Y stage 32a, the linear motor LM2, and the linear guide LG2, thereby prohibiting occurrence of an error between the pattern on the mold 100 and the processing object 200.

Constituting the Y-direction movement means 32 in this manner enables driving of the linear motor LM2 to move the processing object 200 held by the object holding means 20 precisely in the Y direction at a predetermined distance.

Although the explanation has been given of a case where the linear motor LM2 is used for driving the Y-direction movement means 32, the invention is not limited to this case if the processing object 200 can be moved in the Y direction, and, for example, the Y stage 32a may be linked to a ball screw fixed to the base mount 16, and moved by driving of a rotary motor linked to the ball screw.

The rotation means 33 comprises a θ stage 33a which is provided on the Y stage 32a, and supports the object holding means 20, a motor (not illustrated) e.g., a stepping motor which can rotate the θ stage 33a in a rotational direction (hereinafter called θ direction), and an encoder (not illustrated) which detects the rotation angle of the stepping motor, and can transmit detection information on the rotation angle to control means to be discussed later. A material having a high rigidity is used for the θ stage 33a, thereby prohibiting occurrence of an error between the pattern on the mold 100 and the processing object 200.

By constituting the rotation means 33 in this manner, the control means can control driving of a motor M based on the detection information from the encoder, so that the processing object 200 held by the object holding means 20 can be precisely rotated in the rotation direction at an arbitrary angle.

As illustrated in FIG. 3, the mold holding means 40 has a mold holding unit 41 for holding the mold 100 on one end thereof, and the projected spherical surface seat 47 fixed to the other end thereof.

The projected spherical surface seat 47 has an inclination fixed with respect to the mold 100, and the projected spherical surface 46 taking the center of the pattern face 100a of the mold 100 as the center. As illustrated in FIG. 3, the projected spherical surface 46 may be formed on the top face of the projected spherical surface seat 47 projected from the side face of the mold holding means 40 in a flange manner. Possible materials for the projected spherical surface seat 47 are various metals and alloys, such as carbon steel, mold steel, aluminum, titanium, nickel alloy, tungsten, and molybdenum.

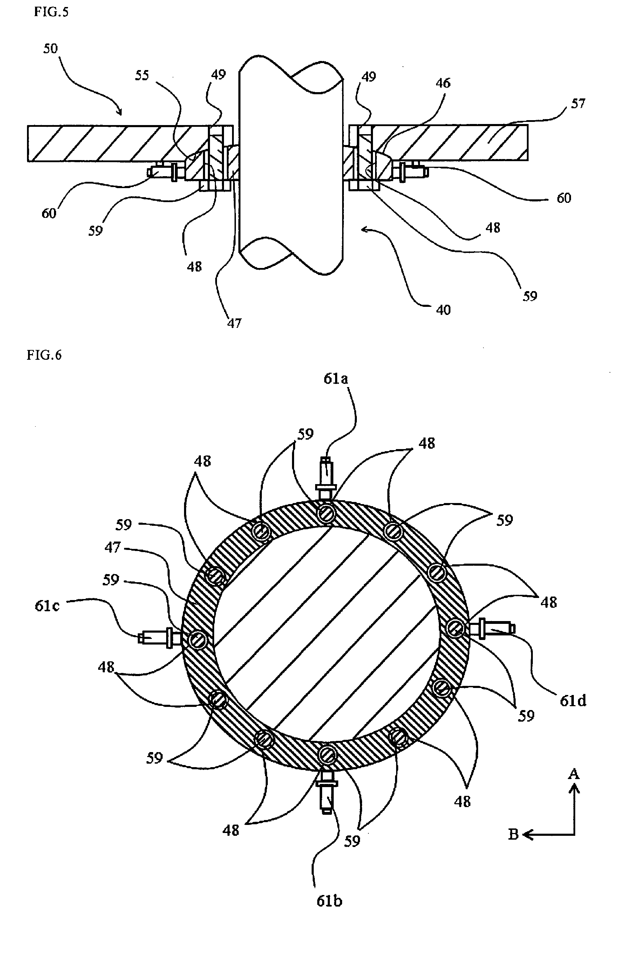

As illustrated in FIG. 5, the projected spherical surface seat 47 has fixing means, e.g., bolts 59 for fixing the projected spherical surface seat 47 and the recessed spherical surface seat 57 together, and through holes 48 into which the bolts 59 are inserted. In this case, it is preferable that the projected spherical surface seat 47 and the recessed spherical surface seat 57 should be fixed together in the normal line direction of the projected spherical surface 46 by bolts in view of prevention of misalignment of the projected spherical surface 46 with the recessed spherical surface 55.

Note that the projected spherical surface seat 47 may be integrally provided on the upper portion of the mold holding means 40.

As illustrated in FIG. 4, the mold holding unit 41 has a plurality of adsorption electrodes 45 provided on a holding face 41 holding the mold 100 in such a manner as to perform surface-contact with the mold 100, and electrostatic force is generated by applying voltage from a non-illustrated power source to the adsorption electrodes 45. The electrostatic force of the adsorption electrodes 45 enables adsorption and holding of the top face of the mold 100. The degree of adhesion between the mold 100 and the adsorption electrodes 45 can be enhanced by increasing the flatnesses of the adsorption electrodes 45 and the top face of the mold 100, so that thermal conduction from the mold holding unit 41 to the mold 100 is effective in comparison with a structure that the mold 100 is fixed to the mold holding unit 41 by screws, clamp brackets, or the like. For holding the hardware 100, it is also possible to employ a structure such that the mold is fixed to the mold holding unit 41 by a fastener like a screw or a clamp bracket, a structure such that the mold is joined with the mold holding unit 41 by welding or the like, a structure such that the mold is adsorbed and held by the mold holding unit 41 by vacuum adsorption, and a structure such that the mold is fitted to the mold holding unit 41.

The mold holding means 40 has built-in heating means for heating the mold 100, e.g., a heater 42. A preferable heater 42 is a so-called ceramic heater formed of a ceramic material like aluminum nitride and having a wiring as a heater electrode embedded therein. As a current is caused to pass the heater electrode from a non-illustrated power source, the temperature of the mold 100 held by the mold holding unit 41 rises, and as the current is cut off, the temperature falls. The ceramic heater is a heater responding so quickly that the temperature rises at a rate of, for example, 100 °C/sec. Current supply from the power source to such a heater electrode is controlled by a non-illustrated controller.

As illustrated in FIG. 3, the mold holding means 40 may have a cooling block (mold cooling means) 43 integrally provided on the heater 42. The cooling block 43 is formed of a metal having a high thermal conductivity, such as aluminum, or copper, and has a channel 44 formed thereinside. As a coolant like a cooling water is caused to flow through the channel 44, the mold 100 is cooled down.

As illustrated in FIG. 3, the mold holding means 40 has a supersonic vibration unit 70, which is comprised of a piezoelectric device 71 and a supersonic horn 72 attached to the bottom face of the piezoelectric device 71, on the other end side of the mold holding unit 41. Note that when alternating current voltage is applied to the piezoelectric device 71 from a non-illustrated driving circuit, the piezoelectric device generates vibration at the frequency of the alternating current voltage in the longitudinal direction, i.e., a direction connecting a Z stage 54 with the mold holding unit 41 (direction in which the mold 100 becomes away from the processing object 200). The supersonic horn 72 has an upper end 72a as a fixed end, and a bottom end 72b as a free end. Accordingly, as the piezoelectric device 71 vibrates, the bottom end 72b of the supersonic horn 72 amplifies vibration, so that the vibration becomes maximum at the mold 100 attached to the bottom end 72b of the supersonic horn 72. In this manner, because vibration of the bottom end 72 which is the free end is large relative to the upper end 72a which is the fixed end (becomes maximum amplitude) in the supersonic horn 72, the upper end 72a can be fixed by an appropriate mechanical fastening member like a bolt, but if the mechanical fastening member is used for the bottom end 72b, there is a possibility that the mechanical fastening member is broken by vibration. Accordingly, the mold holding unit 41 is fixed to the bottom end 72b of the supersonic horn 72 by bonding, fusion bonding (including soldering, brazing) using a low melting metal or the like, or a general welding, not using a mechanical fastening member.

Meanwhile, a structure such that the mold 100 is adsorbed on the mold holding unit 41 by electrostatic force, and a structure such that the processing object 200 is adsorbed on the holding stage 21 by electrostatic force are possible. If such structures are employed, however, electrical charges are transferred between the mold 100 and the processing object 200 when the mold holding unit 41 comes close to the holding stage 21 in molding the processing object 200 by the mold 100, and then when the mold 100 becomes away from the processing object 200, either the mold 100 or the processing object 200 may be possibly adsorbed by the other, so that such structures are not preferable. Therefore, in a case where the mold 100 is adsorbed on the mold holding unit 41 by electrostatic force, it is preferable that the processing object 200 should be held on the holding stage 21 by a scheme other than electrostatic force, and in a case where the processing object 200 is adsorbed on the holding stage 21 by electrostatic force, it is preferable that the mold 100 is held on the mold holding unit 41 by a scheme other than electrostatic force.

Further, the mold holding means 40 is formed in such a manner as to be displaced by X-direction movement means 31 movable relatively and linearly in a direction orthogonal to the Y direction (hereinafter called X direction) within a plane parallel to the top face of the processing object 200. It is preferable that the X-direction movement means 31 and the Y-direction movement means should be orthogonal to each other.

The X-direction movement means 31 is formed in, for example, a substantially square cylindrical shape surrounding the two upper bases 18, and comprises an X stage 31a which holds the mold holding means 40, a linear motor LM1 which is fixed to the individual upper bases 18 parallel to the ground and applies driving force in the X direction to the X stage 31a, and a linear guide LG1 fixed to the individual upper bases 18 parallel to the ground, and supports the X stage 31a movable in the D direction. A hole through which the mold holding means 40 can pass is formed in the bottom face of the X stage 31a. Materials having a high rigidity are used for the X stage 31a, the linear motor LM1, and the linear guide LG1, and this prohibits occurrence of an error between the pattern on the mold 100 and the processing object 200.

Constituting the X-direction movement means 31 in this manner enables the mold 100 held by the mold holding unit 41 to precisely move in the X direction at a predetermined distance by driving of the linear motor LM1.

The explanation has been given of a case where the linear motor LM1 is used for driving the X-direction movement means 31, but the invention is not limited to this case if the mold 100 can be moved in the X direction, and for example, the X stage 31a may be linked to a ball screw fixed to the upper base 18, and moved by driving of a rotary motor linked to the ball screw.

The X stage 31a is provided with movement-mechanism cooling means, e.g., a non-illustrated fan, and this causes an airflow to repel the heat in the device 10. Therefore, it is possible to suppress members constituting the device 10 from causing thermal expansion or the like, and control precise positioning of the pattern on the mold 100 and the processing object 200.

The reason why the X-direction movement means is formed on the mold holding means 40 side and the Y-direction movement means is formed on the object holding means 20 side is to simplify the structure of the movement mechanism 30, thereby enhancing precisions of the X-direction movement means, the Y-direction movement means, and the θ-direction movement means. Regarding the position where each movement means is provided, however, the movement means may be provided on either side of the mold holding means 40 and the object holding means 20 as long as the mold 100 and the processing object 200 can be moved relatively and precisely, and, for example, all of the X-direction movement means, the Y-direction movement means, and the θ-direction movement means may be integrally provided on the mold holding means 40 side or the object holding means 20 side.

As illustrated in FIG. 2, the press means 50 is connected to the recessed spherical surface seat 57 which abuts with the projected spherical surface seat 47, and is for pressing the pattern face 100a of the mold 100 against the surface of the processing object 200 through the projected spherical surface seat 47 and the mold holding means 40 by pressing the recessed spherical surface seat 57.

As illustrated in FIG. 2, the press means 50 comprises a plurality of (in the embodiment, four) poles 53 connected to the internal top face and bottom face of the X stage 31a, a Z stage 54 fitted to the poles 53, movable upwardly and downwardly in a direction orthogonal to the X direction and the Y direction (hereinafter called Z direction), and having a hole through which the mold holding means 40 can pass, a bracket 56 supported by a plurality of poles provided on the Z stage 54, and crossing the mold holding means 40, a ball screw 51 linking the X stage 31a with the top face of the bracket 56, and a motor 52 for rotationally driving the ball screw 51. The bottom portion of the ball screw 51 and the top face of the bracket 56 are coupled together through a bearing mechanism 58. Employing such a structure permits the Z stage 54 to move up and down without rotation. The mold holding means 41 that holds the mold 100 moves up and down together with the movement of the Z stage, and can come close, press, and move away with respect to the processing object 200 held on the holding stage 21.

Further, the Z stage 54 has the recessed spherical surface seat 57 provided on the bottom face thereof and having the recessed spherical surface 55 with the same diameter as that of the projected spherical surface 46 of the mold hold means 40. The recessed spherical surface seat 57 may be provided separately from the Z stage 54, and fixed thereto by means of a bolt, welding, or the like as illustrated in FIG. 2, or it is not illustrated but may be provided integrally with the Z stage 54.

The recessed spherical surface seat 57 has the recessed spherical surface 55 which abuts with the projected spherical surface 46, and has the same diameter as that of the projected spherical surface 46. The recessed spherical surface 55 has an inclination fixed with respect to the processing object through the press means 50, the device main body 15, and the object holding means 20. Possible materials of the recessed spherical surface seat 57 are various metals and alloys, such as carbon steel, mold steel, aluminum, titanium, nickel alloy, tungsten, and molybdenum. The recessed spherical surface 55 is fixed by fixing means, e.g., bolts 59 while abutting with the projected spherical surface 46. The bolts 59 are threaded with female screws 49 provided on the recessed spherical surface 55 side via through holes 48 each having a slightly larger diameter than the diameter of the bolt 59 provided on the projected spherical surface 46 side, to be more precise, a diameter larger than the maximum width for causing the projected spherical surface 46 and the recessed spherical surface 55 to be relatively displaced when the inclination of the mold 100 is adjusted by displacement means 60 to be discussed later. Accordingly, even if the projected spherical surface 46 and the recessed spherical surface 55 are relatively displaced in adjusting the inclination, the bolts 59 do not interfere with the mold holding means 40. Note that substituting the bolts 59 with a clamp mechanism using hydraulic pressure or a servo motor enables automatic inclination adjustment.

It is preferable that topcoat layers having a hardness higher than those of the base materials of the projected spherical surface 46 and the recessed spherical surface 55 or topcoat layers having a small coefficient of friction should be formed on the projected spherical surface 46 of the projected spherical surface seat 47 and the recessed spherical surface 55 of the recessed spherical surface seat 57 for the purpose of wear prevention. In this case, possible topcoat processes for improving the hardness are carburization, nitriding, chrome-plating, nickel-plating, as well as a method of forming a chromium nitride film, a titanium nitride film, a diamond-like carbon film, or the like. A possible topcoat process for reducing the coefficient of friction is a method of forming a Teflon coating or a diamond-like carbon film. Further, it is preferable that a grease as a lubricant should be applied between the projected spherical surface 46 and the recessed spherical surface 55. In particular, it is preferable that a grease containing a Teflon-based additive should be used to reduce the sliding resistance.

As illustrated in FIG. 5 and FIG. 6, the displacement means 60 comprises adjusting instruments, e.g., micro gauges fixed to, for example, the recessed spherical surface seat 57. In this case, the micro gauges may include a first micro gauge 61a (first adjusting instrument) and a second micro gauge 61b (second adjusting instrument) pressing the side faces of the projected spherical surface seat 47 in directions opposite to each other, and a third micro gauge 61c (third adjusting instrument) and a fourth micro gauge 61d (fourth adjusting instrument) pressing the side faces of the projected spherical surface seat 47 in directions (hereinafter called B direction) orthogonal to the press directions of the first micro gauge 61a and the second micro gauge 61b (hereinafter called A directions), and opposite to each other. This allows the projected spherical surface 46 of the projected spherical surface seat 47 to be displaced in a free direction with respect to the recessed spherical surface seat 55 of the recessed spherical surface seat 57, thereby enabling adjustment of a relative inclination of the mold 100 held by the mold holding means 40 with the processing object 200 held by the object holding means 20. The number and positions of the adjusting instruments can be changed variously, and the side faces of the projected spherical surface seat 47 may be pressed in at least three different directions by greater than or equal to three adjusting instruments. The adjusting instrument may be in any forms as long as the projected spherical surface 46 of the projected spherical surface seat 47 can be displaced in a free direction with respect to the recessed spherical surface 55 of the recessed spherical surface seat 57, and for example, an actuator can be used.

If the projected spherical surface 46 and the recessed spherical surface 55 are not fixed together by fixing means so as to be displaced freely, and the foregoing topcoat layers having a small coefficient of frequency are formed on the projected spherical surface 46 and the recessed spherical surface 55, the projected spherical surface 46 and the recessed spherical surface 55 slide each other, and are displaced when the mold 100 and the processing object 200 are pressed, so that the inclination of the mold 100 with the processing object 200 can be passively displaced. In this case, the displacement means 60 becomes unnecessary. For example, the projected spherical surface seat may be disposed on the recessed spherical surface seat, and the object holding means 20 which holds the processing object 200 may be fixed on the projected spherical surface seat.

An explanation will be given of an inclination adjusting method of such a pattern formation device below.

First, the inclination of the mold 100 is detected by inclination detection means to be discussed later. An inclination adjusting width $a_1$ that is an error between the mold 100 and the processing object 200 in the A direction with respect to the Z direction are calculated and acquired from information on the detected inclination. Next, a width $a_2$ that the first or second micro gauge presses the side face of the mold holding means 40 for adjustment is calculated and acquired from the adjusting width $a_1$. For example, in a case where the adjusting width $a_1$ is calculated at a place on the pattern face 100a and away from the center of the pattern face 100a by r, $a_2$ can be calculated from:

$$a_2 = a_1 \cdot R/r$$

where R represents a distance (radius of the projected spherical surface 46) from the center of the pattern face 100a on the mold 100 to the projected spherical surface 46 in the equation. Likewise, an inclination adjusting width $b_2$ in the B direction can be calculated from an inclination adjusting width $b_1$ of the mold 100 and the processing object 200 in the B direction.

The first to fourth micro gauges are adjusted based on the adjusting widths $a_2$, $b_2$, and the projected spherical surface 46 and the recessed spherical surface 55 are relatively displaced, thereby adjusting the inclination of the pattern face 100a on the mold 100 with the processing object 200 precisely.

The setting ability of adjusting the inclination depends on the setting abilities of the micro gauges and the ratio of R to r. For example, in a case where the setting abilities of the micro gauges are 0.5 $\mu$m, and the ratio of R to r is 10, the minimum setting ability to be able to adjust the inclination of the mold 100 becomes 50 nm. Therefore, the setting ability can be much fine by increasing the distance from the center of the mold 100 to the projected spherical surface 46, or by using a micro gauge having a more fine setting ability.

The pattern formation device may further comprise the inclination detection means which detects a relative inclination of the mold 100 with the processing object 200, and control means which controls the displacement means 60 based on the inclination detected by the inclination detection means, and adjusts an amount of displacement of relatively displacing the projected spherical surface 46 and the recessed spherical surface 55 to automatically perform adjustment of the inclination.

The inclination detection means comprise, for example, a capacitive electric micrometer which can measure a distance between the mold 100 and the processing object 200 from a change in a capacitance. The relative inclination of the mold 100 with the processing object 200 can be detected as the capacitive electric micrometer is caused to measure a distance between arbitrary three points not on the same straight line on the pattern face 100a on the mold 100 and the processing object 200. The inclination detection means may be in any forms as long as it can detect the relative inclination of the mold 100 with the processing object 200, and for example, an air micrometer can be used.

The control means comprises, for example, a CPU, and is structured in such a manner as to calculate the width $a_2$ that the first micro gauge and the second micro gauge cause the side faces of the projected spherical surface seat 47 to be displaced in the A direction and the width $b_2$ that the third micro gauge and the fourth micro gauge cause the side faces of the projected spherical surface seat 47 to be displaced in the B direction based on information on the inclination detected by the inclination detection means, and control the first to fourth micro gauges to adjust the relative displacement between the projected spherical surface 46 and the recessed spherical surface 55.

Specifically, in a case where the inclination adjusting width between the mold 100 and the processing object 200 in the A direction is $a_1$ as mentioned above, the width $a_2$ to be adjusted by the first or second micro gauge will be calculated as:

$$a_2 = a_1 \cdot R/r$$

Likewise, the width $b_2$ in the B direction to be adjusted by the third or fourth micro gauge will be calculated from the inclination adjusting width $b_1$ between the mold 100 and the processing object 200 in the B direction. This enables automatic adjustment of the relative inclination of the mold 100 with the processing object 200. Note that it is possible to employ a structure such that a clamp mechanism is used as fastener means for fastening the projected spherical surface 46 and the recessed spherical surface 55 together and the projected spherical surface 46 and the recessed spherical surface 55 are separated away under the control of the control means when the inclination is adjusted.

Although the explanation has been given of a structure such that the projected spherical surface seat 47 is provided on the mold holding means 40 side while the recessed spherical surface seat 57 is provided on the press means 50 in the embodiment, a structure such that the recessed spherical surface seat is provided on the mold holding means 40 while the projected spherical surface seat is provided on the press means 40 may be employed.

Moreover, the explanation has been given of a case where the projected spherical surface seat 47 and the recessed spherical surface seat 57 are provided on the mold holding means 40 side, but the invention is not limited to this case, and the projected spherical surface seat and the recessed spherical surface seat may be provided on the object holding means 20 side.

Second Embodiment

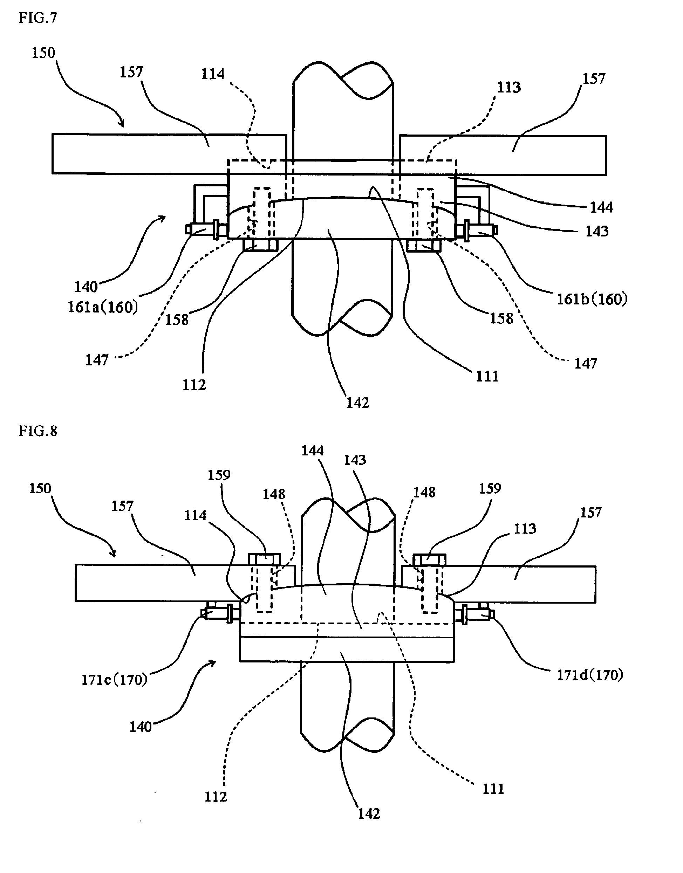

As illustrated in FIG. 7 and FIG. 8, a pattern formation device according to another embodiment of the invention uses a first circular-arcuate surface seat 142, a first recessed circular-arcuate surface seat 143, a second circular-arcuate surface seat 144, a second recessed circular-arcuate surface seat 157, first displacement means 160, and second displacement means 170, instead of the projected spherical surface seat 47, the recessed spherical surface seat 57, and the displacement means 60 of the pattern formation device in the first embodiment. The first projected circular-arcuate surface seat 142, the first recessed circular-arcuate surface seat (second projected circular-arcuate surface seat) 143, the second recessed circular-arcuate surface seat 157, the first displacement means 160, and the second displacement means 170 constitute an inclination adjusting device. Because other structural portions are the same as those of the first embodiment, the same portions as those of the first embodiment will be denoted by the same reference symbols to omit explanations thereof.

Mold holding means 140 has the mold holding unit 41 on the one end thereof to hold the mold 100, and the first projected circular-arcuate surface seat 142, which abuts with the first recessed circular-arcuate surface seat 143, fixed to the other end thereof.

The first projected circular-arcuate surface seat 142 has an inclination fixed to the mold 100, and a first projected circular-arcuate surface 111 whose cut plane centered on a first central line passing through the center of the pattern face 100a on the mold 100 is formed in a projected circular arcuate shape. As illustrated in FIG. 7 and FIG. 8, the first projected circular-arcuate surface seat 142 is formed in a flange-like shape on the side face of the mold holding means 140, and is fastened by a bolt, welding, or the like. Needless to say, it may be provided integrally with the mold holding means 140. The first projected circular-arcuate surface seat 142 may be provided at the upper end portion of the mold holding means 140. Possible materials for the first projected circular-arcuate surface seat 142 are various metals and alloys, such as carbon steel, mold steel, aluminum, titanium, nickel alloy, tungsten, and molybdenum.

The first recessed circular-arcuate surface seat 143 has a first recessed circular-arcuate surface 112 whose cut plane is formed in a recessed circular-arcuate shape having the same diameter as that of the first projected circular-arcuate surface 111 and which abuts with the first projected circular-arcuate surface. The first recessed circular-arcuate surface seat 143 is provided integrally with the second projected circular-arcuate surface seat 144, so that an inclination of the first recessed circular-arcuate surface 112 with a second projected circular-arcuate surface 113 is fixed. It is not necessary that the first recessed circular-arcuate surface seat 143 and the second projected circular-arcuate surface seat 144 are so provided as to be integral with each other, and they may be fixed together by a bolt, welding, or the like as long as the inclination of the first recessed circular-arcuate surface 112 with the second projected circular-arcuate surface 113 can be fixed.

The second projected circular-arcuate surface seat 144 has an inclination fixed to the first recessed circular-arcuate surface 112, and the second projected circular-arcuate surface 113 whose cut plane is formed in a projected circular-arcuate shape, and which is formed in a predetermined direction not parallel to the axial direction (direction of the first central line) of the first recessed circular-arcuate surface 112. It is desirable that the first projected circular-arcuate surface 111 and the second projected circular-arcuate surface 113 should be formed in such a way that the axial direction of the arcs thereof are orthogonal to each other. It is preferable that the axis of the second projected circular-arcuate surface 113 should pass through the center of the pattern face 100a on the mold 100. The first projected circular-arcuate surface 111 and the second projected circular-arcuate surface 113 may be so formed as to have the same diameter.

The second projected circular-arcuate surface seat 144 is formed independently from the first projected circular-arcuate surface seat 142, and has a hollow through which the head of the mold holding means 140 can pass on the center thereof. In a case where the first projected circular-arcuate surface seat 142 is provided at the upper end portion of the mold holding means 140, however, the hollow is unnecessary. The first projected circular-arcuate surface seat 142 and the first recessed circular-arcuate surface seat 143 are fixed by first fixing means like bolts 158 with the first projected circular-arcuate surface 111 and the first recessed circular-arcuate surface 112 abutting with each other. The bolt 158 passes through a through hole 147 having a diameter slightly larger than the diameter of the bolt 158 provided on the first projected circular-arcuate surface seat 142, to be more precise, a diameter larger than a maximum width of causing the first projected circular-arcuate surface 111 and the first recessed circular-arcuate surface 112 to be relatively displaced when the inclination of the mold 100 is adjusted by the first displacement means 160 to be discussed later, and is threaded with a female screw provided on the first recessed circular-arcuate surface seat 143 side.

Possible materials for the first recessed circular-arcuate surface seat 143 and the second projected circular-arcuate surface seat 144 are various metals and alloys, such as carbon steel, mold steel, aluminum, titanium, nickel alloy, tungsten, and molybdenum.

The second recessed circular-arcuate surface seat 157 has a second recessed circular-arcuate surface 114 whose cut plane is formed in a recessed circular-arcuate shape having the same diameter as that of the second projected circular-arcuate surface 113, and which is formed in such a manner as to abut with the second projected circular-arcuate surface 113. The second recessed circular-arcuate surface 114 has an inclination fixed to the processing object 200 through the press means 50, the device main body 15, and the object holding means 20. Like the first projected circular-arcuate surface seat 142, the first recessed circular-arcuate surface seat 143, and the second projected circular-arcuate surface seat 144, possible materials for the second recessed circular-arcuate surface seat 157 are various metals and alloys, such as carbon steel, mold steel, aluminum, titanium, nickel alloy, tungsten, and molybdenum.

Press means 150 are connected to the second recessed circular-arcuate surface seat 157, and is for pressing the pattern face 100a on the mold 100 against the surface of the processing object 200 through the second projected circular-arcuate surface seat 144, the first recessed circular-arcuate surface seat 143, the first projected circular-arcuate seat 142, and the mold holding means 140 by pressing the second recessed circular-arcuate surface seat 157. For example, like the first embodiment, the second recessed circular surface seat 157 may be formed at the bottom face of the Z stage 54.

The second recessed circular-arcuate surface 114 is fixed by second fixing means, e.g., bolts 159 while abutting with the second projected circular-arcuate surface 113 of the second projected circular surface seat 144. The bolt 159 passes through a through hole 148 having a diameter slightly larger than the diameter of the bolt 159 provided on the second recessed circular-arcuate surface seat 157 side, to be more precise, a diameter larger than a maximum width of causing the second projected circular-arcuate surface 113 and the second recessed circular-arcuate surface 114 to be relatively displaced when the inclination of the mold 100 is adjusted by the second displacement means 170 to be discussed later, and threaded with a female screw provided on the second projected circular-arcuate surface seat 144 side.

As illustrated in FIG. 7, the first displacement means 160 comprises, for example, a first micro gauge 161a (first adjusting instrument) and a second micro gauge 161b (second adjusting instrument) which press the side faces of the first projected circular-arcuate surface seat 142 in directions opposite to each other. The first micro gauge 161a and the second micro gauge 161b are fixed to the respective side faces of the first recessed circular-arcuate surface seat 143, and press the side faces of the first projected circular-arcuate surface seat 142, thereby causing the first projected circular-arcuate surface 111 to be displaced with respect to the first recessed circular-arcuate surface 112 in a predetermined first direction.

The adjusting instrument may be in any forms as long as the first projected circular-arcuate surface 111 of the first projected circular-arcuate surface seat 142 can be displaced in the predetermined first direction with respect to the first recessed circular-arcuate surface 112 of the first recessed circular-arcuate surface seat 143, and for example, may be an actuator.

As illustrated in FIG. 8, the second displacement means 170 comprises a third micro gauge 171c (third adjusting instrument) and a fourth micro gauge 171d (fourth adjusting instrument) which press the side faces of the second projected circular-arcuate surface seat 144 in second directions orthogonal to the first directions at which the first displacement means 160 presses, and opposite to each other. The third micro gauge 171c and the fourth micro gauge 171d are respectively fixed to the second recessed circular-arcuate surface seat 157, and press the side faces of the second projected circular-arcuate surface seat 144, thereby causing the second projected circular-arcuate surface 113 to be displaced in the second directions with respect to the second recessed circular-arcuate surface 114.

The adjusting instrument may be in any forms as long as the second projected circular-arcuate surface 113 of the second projected circular-arcuate surface seat 144 can be displaced in the predetermined first direction with respect to the second recessed circular-arcuate surface 114 of the second recessed circular-arcuate surface seat 157, and for example, may be an actuator.

As mentioned above, in the second embodiment, because inclination adjustment in directions orthogonal to one another is set apart by the first projected circular-arcuate surface seat 142 and the first recessed circular-arcuate surface seat 143, and the second projected circular-arcuate surface seat 144 and the second recessed circular-arcuate surface seat 157, interference to one inclination originating from adjustment of the other inclination caused by a fabrication error is eliminated, thereby enabling more precise inclination adjustment. There is an advantage such that processing of circular-arcuate surface is easier than processing of spherical surface.

It is preferable that the first projected circular-arcuate surface 111, the first recessed circular-arcuate surface 112, the second projected circular-arcuate surface 113, and the second recessed circular-arcuate surface 114 of the mold holding means 140 should have topcoat layers having a higher hardness than those of the respective base materials thereof, or topcoat layers having a smaller coefficient of friction formed for wear prevention. In this case, possible topcoat processes for improving the hardness are carburization, nitriding, chrome-plating, nickel-plating, as well as a method of forming a chromium nitride film, a titanium nitride film, a diamond-like carbon film, or the like. A possible topcoat process for reducing the coefficient of friction is a method of forming a Teflon coating or a diamond-like carbon film. Further, it is preferable that a grease as a lubricant should be applied between the first projected circular-arcuate surface 111 and the first recessed circular-arcuate surface 112 and between the second projected circular-arcuate surface 113 and the second recessed circular-arcuate surface 114. In particular, it is preferable that a grease containing a Teflon-based additive should be used to reduce the sliding resistance.

If the first projected circular-arcuate surface 111, the first recessed circular-arcuate surface 112, the second projected circular-arcuate surface 113, and the second recessed circular-arcuate surface 114 are set in such a manner as to be freely displaced without being fixed by the first fixing means and the second fixing means, and the foregoing topcoat layers having a low coefficient of friction are formed on the first projected circular-arcuate surface 111, the first recessed circular-arcuate surface 112, the first projected circular-arcuate surface 113, and the second recessed circular-arcuate surface 114, the first projected circular-arcuate surface 111 and the first recessed circular-arcuate surface 112, and the second projected circular-arcuate surface 113 and the second recessed circular-arcuate surface 114 are slid to be displaced when the mold 100 and the processing object 200 are pressed, thereby passively displacing the inclination of the mold 100 with the processing object 200. In this case, the first displacement means 160 and the second displacement means 170 become unnecessary. For example, the second projected circular-arcuate surface seat may be disposed on the second recessed circular-arcuate surface seat, the first recessed circular-arcuate surface seat may be fixed on the second projected circular-arcuate surface seat, the first projected circular-arcuate surface seat may be disposed on the first recessed circular-arcuate surface seat may be disposed on the first recessed circular-arcuate surface seat, and the object holding means 20 which holds the processing object 200 may be fixed on the first projected circular-arcuate surface seat.

Note that the pattern formation device may further comprise inclination detection means which detects a relative inclination between the mold 100 and the processing object 200, and control means which controls displacement of the displacement means 60 based on the inclination detected by the inclination detection means so as to be structured in such a manner as to automatically performs adjustment of the inclination like the first embodiment.

Next, an explanation will be given of an adjusting method of the inclination of the mold 100 in such a pattern formation device.

First, the inclination of the mold 100 is detected through the inclination detection means. An inclination adjusting width $C_1$ which is an error between the mold 100 and the processing object 200 in the first direction with respect to the Z direction is calculated and obtained. Next, a width $C_2$ to be adjusted by the first or second micro gauge which presses the side face of the first projected circular-arcuate surface seat 142 of the mold holding means **140** is calculated and obtained from the adjusting width $C_1$. For example, in a case where the adjusting width $C_1$ is calculated at a place on the pattern face 100a and away from the first central line of the pattern face 100a by $r_1$, $C_2$ is calculated as:

$$C_2 = C_1 \cdot R_1 / r_1$$

where $R_1$ represents a distance from the central line of the pattern face 100a on the mold 100 to the first projected circular-arcuate surface 111 (radius of the first projected circular-arcuate surface 111) in the equation. Regarding a width $d_2$ to be adjusted by the third or fourth micro gauge which presses the side face of the second projected circular-arcuate surface seat 144, with an adjusting width of an inclination of the mold 100 with the processing object 200 in the second direction being $d_1$, and a distance (radius of the second projected circular-arcuate surface 113) from the central line of the pattern face 100a on the mold 100 to the second projected circular-arcuate surface 113 being $R_2$, in a case where the adjusting width $d_1$ is calculated at a place on the pattern face 100a and away from the second central line of the pattern face 100a by $r_2$, $d_2$ is calculated as:

$$d_2 = d_1 \cdot R_2 / r_2$$

The first to fourth micro gauges 161a to 161d are adjusted based on the adjusting widths $C_2$, $d_2$ to cause the first projected circular-arcuate surface 111 and the first recessed circular-arcuate surface 112, and, the second projected circular-arcuate surface 113 and the second recessed circular-arcuate surface 114 to be relatively displaced, thereby precisely adjusting the inclination of the pattern face 100a on the mold 100 with the processing object 200.

It is needless to say that the pattern formation device of the second embodiment may be structured in such a manner as to further comprise inclination detection means which detects the relative inclination of the mold 100 with the processing object 200 and control means which controls the first displacement means 160 and the second displacement means 170 based on the inclination detected by the inclination detection means, and adjusts the displacement of causing the first projected circular-arcuate surface 111 and the first recessed circular-arcuate surface 112 to be relatively displaced, and, the displacement of causing the second projected circular-arcuate surface 113 and the second recessed circular-arcuate surface 114 to be relatively displaced to automatically adjust the inclination like the first embodiment.

In this case, the control means comprises, for example, a CPU, and is structured in such a manner as to calculate the width $C_2$ that the first micro gauge and the second micro gauge cause the side faces of the first projected circular-arcuate surface seat 142 to be displaced in the first direction and the width $d_2$ that the third micro gauge and the fourth micro gauge cause the side faces of the second projected circular-arcuate surface seat 144 to be displaced in the second direction based on information on the inclination detected by the inclination detection means, and control the first to fourth micro gauges to adjust the relative displacements of the first projected circular-arcuate surface 111 and the first recessed circular-arcuate surface 112, and, the second projected circular-arcuate surface 113 and the second recessed circular-arcuate surface 114.

Specifically, in a case where the inclination adjusting width between the mold 100 and the processing object 200 in the first direction is $c_1$ as mentioned above, with the distance (radius of the first projected circular-arcuate surface 111) from the central line of the pattern face 100a on the mold 100 to the first projected circular-arcuate surface 111 being $R_1$, the width $C_2$ to be adjusted by the first or second micro gauge will be calculated as:

$$c_2 \ = \ c_1 {\cdot} R_1 / r_1$$

Likewise, the width $d_2$ in the second direction to be adjusted by the third or fourth micro gauge will be calculated from the inclination adjusting width $d_1$ between the mold 100 and the processing object 200 in the second direction, and the distance (radius of the first projected circular-arcuate surface 111) $R_2$ from the central line of the pattern face 100a to the second projected circular-arcuate surface 113 as:

$$d_2 \ = \ d_1 {\cdot} R_2 / r_2$$

This enables automatic adjustment of the relative inclination of the mold 100 with the processing object 200. Note that it is possible to employ a structure such that clamp mechanisms are used as fastener means for fastening the first projected circular-arcuate surface seat 142 and the first recessed circular-arcuate surface seat 143 together, and the second projected circular-arcuate surface seat 144 and the second recessed circular-arcuate surface seat 157 together, and the first projected circular-arcuate surface 111 and the first recessed circular-arcuate surface 112, and, the second projected circular-arcuate surface 113 and the second recessed circular-arcuate surface 114 are separated away under the control of the control means when the inclination is adjusted.

Although the explanation has been given of a structure such that the first projected circular-arcuate surface seat 142, the first recessed circular-arcuate surface seat 143, the second projected circular-arcuate surface seat 144, and the second recessed circular-arcuate surface seat 157 are provided in this order from the mold holding means 40 side in the foregoing embodiment, it is possible to employ a structure such that the first recessed circular-arcuate surface seat, the first projected circular-arcuate surface seat, the second recessed circular-arcuate surface seat, and the second projected circular-arcuate surface seat are provided in this order from the mold holding means 40.

In the foregoing embodiment, the explanation has been given of a case where the first projected circular-arcuate surface seat 142, the first recessed circular-arcuate surface seat 143, the second projected circular-arcuate surface seat 144, and the second recessed circular-arcuate surface seat 157 are provided on the mold holding means 40 side, but the invention is not limited to this case, and it is needles to say that the first projected circular-arcuate surface seat, the first recessed circular-arcuate surface seat, the second projected circular-arcuate surface seat, and the second recessed circular-arcuate surface seat may be provided on the object holding means 20 side.

Industrial Applicability

According to the invention, an inclination of the mold with the processing object can be precisely adjusted by a simple operation. Because the displacement means (first adjusting instrument, second adjusting instrument, third adjusting instrument, and the fourth adjusting instrument) can be displaced at positions where suppress force applied between the mold and the processing object does not affect, the displacement means is not to be deformed, and this enables highly precise inclination adjustment even if the device is used for a long period.

**Claims**

1. An inclination adjusting device included in a pattern formation device that presses a mold, which has a predetermined pattern, and a processing object to transfer said pattern of said mold on said processing object, adjusting an inclination of said mold with said processing object, and comprising:

a projected spherical surface seat having a projected spherical surface whose inclination is fixed with respect to said mold; and
a recessed spherical surface seat having a recessed spherical surface which has a same diameter as a diameter of said projected spherical surface and an inclination fixed with respect to said processing object, and abuts with said projected spherical surface.

2. An inclination adjusting device included in a pattern formation device that presses a mold, which has a predetermined pattern, and a processing object to transfer said pattern of said mold on said processing object, adjusting an inclination of said mold with said processing object, and comprising:

a recessed spherical surface seat having a recessed spherical surface whose inclination is fixed with respect to said mold; and
a projected spherical surface seat having a projected spherical surface which has a same diameter as a diameter of said recessed spherical surface and an inclination fixed with respect to said processing object, and abuts with said recessed spherical surface.

3. The inclination adjusting device according to claim 1 or 2, comprising displacement means for causing said projected spherical surface and said recessed spherical surface to be relatively displaced.

4. The inclination adjusting device according to claim 3, wherein said displacement means comprises a first adjusting instrument and a second adjusting instrument which press said projected spherical surface seat or said recessed spherical surface seat in directions opposite to each other to cause said projected spherical surface and said recessed spherical surface to be relatively displaced, and a third adjusting instrument and a fourth adjusting instrument which presses said projected spherical surface seat or said recessed spherical surface seat in directions orthogonal to press directions of said first adjusting instrument and said second adjusting instrument and opposite to each other to cause said projected spherical surface and said recessed spherical surface to be relatively displaced.

5. The inclination adjusting device according to any one of claims 1 to 3, wherein said projected spherical surface and said recessed spherical surface are formed in such a way that centers of spheres thereof match with a center of said pattern face.

6. The inclination adjusting device according to any one of claims 1 to 3, wherein a topcoat layer having a higher hardness than those of said projected spherical surface and said recessed spherical surface is formed on at least one of said projected spherical surface and said recessed spherical surface.

7. The inclination adjusting device according to any one of claims 1 to 3, wherein a topcoat layer having a smaller coefficient of friction than those of said projected spherical surface and said recessed spherical surface is formed on at least one of said projected spherical surface and said recessed spherical surface.

8. The inclination adjusting device according to claim 3, comprising:

inclination detection means for detecting a relative inclination of said mold with said processing object; and
control means for controlling said displacement means based on an inclination detected by said inclination detection means, and adjusting an displacement of causing said projected spherical surface and said recessed spherical surface to be relatively displaced.

9. A pattern formation device that presses a mold, which has a predetermined pattern, and a processing object to transfer said pattern of said mold on said processing object, comprising:

a projected spherical surface seat having a projected spherical surface whose inclination is fixed with respect to said mold;
a recessed spherical surface seat having a recessed spherical surface which has a same diameter as a diameter of said projected spherical surface and an inclination fixed with respect to said processing object, and abuts with said projected spherical surface; and
press means for pressing said mold and said processing object.

10. A pattern formation device that presses a mold, which has a predetermined pattern, and a processing object to transfer said pattern of said mold on said processing object, comprising:

a recessed spherical surface seat having a recessed spherical surface whose inclination is fixed with respect to said mold;
a projected spherical surface seat having a projected spherical surface which has a same diameter as a diameter of said recessed spherical surface and an inclination fixed with respect to said processing object, and abuts with said recessed spherical surface; and
press means for pressing said mold and said processing object.

11. The pattern formation device according to claim 9 or 10, comprising displacement means for causing said projected spherical surface and said recessed spherical surface to be relatively displaced.

12. The pattern formation device according to claim 11, wherein said displacement means comprises a first adjusting instrument and a second adjusting instrument which press said projected spherical surface seat or said recessed spherical surface seat in directions opposite to each other to cause said projected spherical surface and said recessed spherical surface to be relatively displaced, and a third adjusting instrument and a fourth adjusting instrument which press said projected spherical surface seat or said recessed spherical surface seat in directions orthogonal to press directions of said first adjusting instrument and said second adjusting instrument and opposite to each other to cause said projected spherical surface and said recessed spherical surface to be relatively displaced.

13. The pattern formation device according to any one of claims 9 to 11, wherein said projected spherical surface and said recessed spherical surface are formed in such a way that centers of spheres thereof match with a center of said pattern face.

14. The pattern formation device according to any one of claims 9 to 11, wherein a topcoat layer having a higher hardness than those of said projected spherical surface and said recessed spherical surface is formed on at least one of said projected spherical surface and said recessed spherical surface.

15. The pattern formation device according to any one of claims 9 to 11, wherein a topcoat layer having a smaller coefficient of friction than those of said projected spherical surface and said recessed spherical surface is formed on at least one of said projected spherical surface and said recessed spherical surface.

16. The pattern formation device according to claim 11, comprising:

   inclination detection means for detecting a relative inclination of said mold with said processing object; and
   control means for controlling said displacement means based on an inclination detected by said inclination detection means, and adjusting an displacement of causing said projected spherical surface and said recessed spherical surface to be relatively displaced.

17. An inclination adjusting device included in a pattern formation device that presses a mold, which has a predetermined pattern, and a processing object to transfer said pattern of said mold on said processing object, adjusting an inclination of said mold with said processing object, and comprising:

   a first projected circular-arcuate surface seat having a first projected circular-arcuate surface whose inclination is fixed with respect to said mold, and whose cut plane is formed in a projected circular-arcuate shape;
a first recessed circular-arcuate surface seat having a first recessed circular-arcuate surface whose cut plane is formed in a recessed circular-arcuate shape, and which has a same diameter as a diameter of said first projected circular-arcuate surface, and abuts with said first projected circular-arcuate surface;
a second projected circular-arcuate surface seat having a second projected circular-arcuate surface whose inclination is fixed with respect to said first recessed circular-arcuate surface, and whose cut plane is formed in a projected circular-arcuate shape, and which is formed in a predetermined direction not parallel to an axial direction of said first recessed circular-arcuate surface; and
a second recessed circular-arcuate surface seat having a second recessed circular-arcuate surface whose inclination is fixed with respect to said processing object, and whose cut plane is formed in a recessed circular-arcuate shape, and which has a same diameter as a diameter of said second projected circular arcuate surface, and abuts with said second projected circular-arcuate surface.

18. An inclination adjusting device included in a pattern formation device that presses a mold, which has a predetermined pattern, and a processing object to transfer said pattern of said mold on said processing object, adjusting an inclination of said mold with said processing object, and comprising:

   a first recessed circular-arcuate surface seat having a first recessed circular-arcuate surface whose inclination is fixed with respect to said mold, and whose cut plane is formed in a recessed circular-arcuate shape;
   a first projected circular-arcuate surface seat having a first projected circular-arcuate surface whose cut plane is formed in a projected circular-arcuate shape, and which has a same diameter as a diameter of said first recessed circular-arcuate surface, and abuts with said first recessed circular-arcuate surface;
   a second recessed circular-arcuate surface seat having a second recessed circular-arcuate surface whose inclination is fixed with respect to said first projected circular-arcuate surface, and whose cut plane is formed in a recessed circular-arcuate shape, and which is formed in a predetermined direction not parallel to an axial direction of said first projected circular-arcuate surface; and
   a second projected circular-arcuate surface seat having a second projected circular-arcuate surface whose inclination is fixed with respect to said processing object, and whose cut plane is formed in a projected circular-arcuate shape, and which has a same diameter as a diameter of said second recessed circular arcuate surface, and abuts with said second recessed circular-arcuate surface.

19. The inclination adjusting device according to claim 17 or 18, comprising:

first displacement means for causing said first projected circular-arcuate surface and said first recessed circular-arcuate surface to be relatively displaced; and
second displacement means for casing said second projected circular-arcuate surface and said second recessed circular-arcuate surface to be relatively displaced.

20. The inclination adjusting device according to claim 19, wherein
said first displacement means comprises a first adjusting instrument and a second adjusting instrument which press said first projected circular-arcuate surface seat or said first recessed circular-arcuate surface seat in directions opposite to each other to cause said first projected circular-arcuate surface and said first recessed circular-arcuate surface to be relatively displaced, and
said second displacement means comprises a third adjusting instrument and a fourth adjusting instrument which press said second projected circular-arcuate surface seat or said second recessed circular-arcuate surface seat in directions orthogonal to press directions of said first adjusting instrument and said second adjusting instrument and opposite to each other to cause said second projected circular-arcuate surface and said second recessed circular-arcuate surface to be relatively displaced.

21. The inclination adjusting device according to any one of claims 17 to 19, wherein a topcoat layer having a higher hardness than those of said first projected circular-arcuate surface, said first recessed circular-arcuate surface, said second projected circular-arcuate surface, and said second recessed circular-arcuate surface is formed on at least one or more of said first projected circular-arcuate surface, said first recessed circular-arcuate surface, said second projected circular-arcuate surface, and said second recessed circular-arcuate surface.

22. The inclination adjusting device according to any one of claims 17 to 19, wherein a topcoat layer having a smaller coefficient of friction than those of said first projected circular-arcuate surface, said first recessed circular-arcuate surface, said second projected circular-arcuate surface, and said second recessed circular-arcuate surface is formed on at least one or more of said first projected circular-arcuate surface, said first recessed circular-arcuate surface, said second projected circular-arcuate surface, and said second recessed circular-arcuate surface.

23. The inclination adjusting device according to claim 19, comprising:

inclination detection means for detecting a relative inclination of said mold with said processing object; and
control means for controlling said first displacement means and said second displacement means based on an inclination detected by said inclination detection means, and adjusting an displacement of causing said first projected circular-arcuate surface and said first recessed circular-arcuate surface to be relatively displaced and an displacement of causing said second projected circular-arcuate surface and said second recessed circular-arcuate surface to be relatively displaced.

24. A pattern formation device that presses a mold, which has a predetermined pattern, and a processing object to transfer said pattern of said mold on said processing object, comprising:

a first projected circular-arcuate surface seat having a first projected circular-arcuate surface whose inclination is fixed with respect to said mold, and whose cut plane is formed in a projected circular-arcuate shape;
a first recessed circular-arcuate surface seat having a first recessed circular-arcuate surface whose cut plane is formed in a recessed circular-arcuate shape, and which has a same diameter as a diameter of said first projected circular-arcuate surface, and abuts with said first projected circular-arcuate surface;
a second projected circular-arcuate surface seat having a second projected circular-arcuate surface whose inclination is fixed with respect to said first recessed circular-arcuate surface, and whose cut plane is formed in a projected circular-arcuate shape, and which is formed in a predetermined direction not parallel to an axial direction of said first recessed circular-arcuate surface;
a second recessed circular-arcuate surface seat having a second recessed circular-arcuate surface whose inclination is fixed with respect to said processing object, and whose cut plane is formed in a recessed circular-arcuate shape, and which has a same diameter as a diameter of said second projected circular arcuate surface, and abuts with said second projected circular-arcuate surface; and

press means for pressing said mold and said processing object.

**25.** A pattern formation device that presses a mold, which has a predetermined pattern, and a processing object to transfer said pattern of said mold on said processing object, comprising:

a first recessed circular-arcuate surface seat having a first recessed circular-arcuate surface whose inclination is fixed with respect to said mold, and whose cut plane is formed in a recessed circular-arcuate shape;

a first projected circular-arcuate surface seat having a first projected circular-arcuate surface whose cut plane is formed in a projected circular-arcuate shape, and which has a same diameter as a diameter of said first recessed circular-arcuate surface, and abuts with said first recessed circular-arcuate surface;

a second recessed circular-arcuate surface seat having a second recessed circular-arcuate surface whose inclination is fixed with respect to said first projected circular-arcuate surface, and whose cut plane is formed in a recessed circular-arcuate shape, and which is formed in a predetermined direction not parallel to an axial direction of said first projected circular-arcuate surface;

a second projected circular-arcuate surface seat having a second projected circular-arcuate surface whose inclination is fixed with respect to said processing object, and whose cut plane is formed in a projected circular-arcuate shape, and which has a same diameter as a diameter of said second recessed circular arcuate surface, and abuts with said second recessed circular-arcuate surface; and

press means for pressing said mold and said processing object.

**26.** The pattern formation device according to claim 24 or 25, comprising:

first displacement means for causing said first projected circular-arcuate surface and said first recessed circular-arcuate surface to be relatively displaced; and

second displacement means for casing said second projected circular-arcuate surface and said second recessed circular-arcuate surface to be relatively displaced.

**27.** The pattern formation device according to claim 26, wherein

said first displacement means comprises a first adjusting instrument and a second adjusting instrument which press said first projected circular-arcuate surface seat or said first recessed circular-arcuate surface seat in directions opposite to each other to cause said first projected circular-arcuate surface and said first recessed circular-arcuate surface to be relatively displaced, and

said second displacement means comprises a third adjusting instrument and a fourth adjusting instrument which press said second projected circular-arcuate surface seat or said second recessed circular-arcuate surface seat in directions orthogonal to press directions of said first adjusting instrument and said second adjusting instrument and opposite to each other to cause said second projected circular-arcuate surface and said second recessed circular-arcuate surface to be relatively displaced.

**28.** The pattern formation device according to any one of claims 24 to 26, wherein a topcoat layer having a higher hardness than those of said first projected circular-arcuate surface, said first recessed circular-arcuate surface, said second projected circular-arcuate surface, and said second recessed circular-arcuate surface is formed on at least one or more of said first projected circular-arcuate surface, said first recessed circular-arcuate surface, said second projected circular-arcuate surface, and said second recessed circular-arcuate surface.

**29.** The pattern formation device according to any one of claims 24 to 26, wherein a topcoat layer having a smaller coefficient of friction than those of said first projected circular-arcuate surface, said first recessed circular-arcuate surface, said second projected circular-arcuate surface, and said second recessed circular-arcuate surface is formed on at least one or more of said first projected circular-arcuate surface, said first recessed circular-arcuate surface, said second projected circular-arcuate surface, and said second recessed circular-arcuate surface.

**30.** The pattern formation device according to claim 26, comprising:

inclination detection means for detecting a relative inclination of said mold with said processing object; and

control means for controlling said first displacement means and said second displacement means based on an inclination detected by said inclination detection means, and adjusting an displacement of causing said first projected circular-arcuate surface and said first recessed circular-arcuate surface to be relatively displaced and an displacement of causing said second projected circular-arcuate surface and said second recessed circular-arcuate surface to be relatively displaced.

**31.** The inclination adjusting device according to claim 3, comprising fixing means for fixing said projected spherical surface seat and said recessed spherical surface seat in a normal line direction of said projected spherical surface.

**32.** The pattern formation device according to claim 11, comprising fixing means for fixing said projected spherical surface seat and said recessed spherical surface seat in a normal line direction of said projected spherical surface.

**33.** The inclination adjusting device according to claim 19, comprising:

first fixing means for fixing said first projected circular-arcuate surface seat and said first recessed circular-arcuate surface seat in a normal line direction of said first projected circular-arcuate surface; and
second fixing means for fixing said second projected circular-arcuate surface seat and said second recessed circular-arcuate surface seat in a normal line direction of said second projected circular-arcuate surface.

**34.** The pattern formation device according to claim 26, comprising:

first fixing means for fixing said first projected circular-arcuate surface seat and said first recessed circular-arcuate surface seat in a normal line direction of said first projected circular-arcuate surface; and
second fixing means for fixing said second projected circular-arcuate surface seat and said second recessed circular-arcuate surface seat in a normal line direction of said second projected circular-arcuate surface.

FIG.1

FIG.2

FIG.3

FIG.4

FIG.5

FIG.6

FIG.7

FIG.8

## INTERNATIONAL SEARCH REPORT

| International application No. |
| --- |
| PCT/JP2005/013880 |

A. CLASSIFICATION OF SUBJECT MATTER
*H01L21/027* (2006.01), *B29C59/02* (2006.01), *B30B15/06* (2006.01),
*B81C5/00* (2006.01), *B82B3/00* (2006.01)

According to International Patent Classification (IPC) or to both national classification and IPC

B. FIELDS SEARCHED

Minimum documentation searched (classification system followed by classification symbols)
*H01L21/027* (2006.01), *B29C59/02* (2006.01), *B30B15/06* (2006.01),
*B81C5/00* (2006.01), *B82B3/00* (2006.01)

Documentation searched other than minimum documentation to the extent that such documents are included in the fields searched
Jitsuyo Shinan Koho         1922-1996    Jitsuyo Shinan Toroku Koho    1996-2005
Kokai Jitsuyo Shinan Koho   1971-2005    Toroku Jitsuyo Shinan Koho    1994-2005

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | JP 2004-146601 A (National Institute of Advanced Industrial Science and Technology (AIST)), 20 May, 2004 (20.05.04), Par. No. [0008]; Fig. 6 (Family: none) | 1,2,6,7,9, 10,14,15,17, 18,21,22,24, 25,28,29, 31-34 |
| X | JP 2004-103232 A (KOMAG INC.), 02 April, 2004 (02.04.04), Par. Nos. [0015] to [0025]; Fig. 2 & US 2004/0132301 A1    & DE 10342301 A1 | 1,2,5-7,9, 10,13-15,17, 18,21,22,24, 25,28,29, 31-34 |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search 21 October, 2005 (21.10.05) | Date of mailing of the international search report 01 November, 2005 (01.11.05) |
| --- | --- |
| Name and mailing address of the ISA/ Japanese Patent Office | Authorized officer |
| Facsimile No. | Telephone No. |

Form PCT/ISA/210 (second sheet) (April 2005)

**INTERNATIONAL SEARCH REPORT**

| International application No. |
| --- |
| PCT/JP2005/013880 |

C (Continuation).　DOCUMENTS CONSIDERED TO BE RELEVANT

| Category* | Citation of document, with indication, where appropriate, of the relevant passages | Relevant to claim No. |
| --- | --- | --- |
| P,X | JP 2005-129791 A (Kabushiki Kaisha Nano Tekku), 19 May, 2005 (19.05.05), Par. Nos. [0020] to [0025]; Figs. 3 to 6 (Family: none) | 1,2,9,10 |
| P,X | JP 2005-007848 A (Toppan Printing Co., Ltd.), 13 January, 2005 (13.01.05), Full text (Family: none) | 1,2,9,10, 17-20,23-27, 30-34 |
| A | JP 2001-135634 A (Nippon Telegraph And Telephone Corp.), 18 May, 2001 (18.05.01), Page 1 (Family: none) | 1-34 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- New Technique for Fabricating Nano Structures. **G.M. WHITESIDES ; J. C. LOVE.** Nikkei Science. Nihon Keizai Shinbun, Inc, 01 December 2001, vol. 31, 30-41

- **C. M. SOTOMAYOR.** Nanoimprint lithography: an alternative nanofabrication approach. *Materials Science & Engineering C,* 2002, vol. 989, 1-9